# FASCICULE DE BREVET EUROPEEN

(11) **EP 3 382 762 B1**
(45) Date de publication et mention de la délivrance du brevet: **28.07.2021**
(21) Numéro de dépôt: 17188645.0
(22) Date de dépôt: 30.08.2017
(51) Int. Cl.: B60L 3/00, H01L 27/02, H02J 7/00, H02H 9/04

(54) **DISPOSITIF DE PROTECTION CONTRE DES SURTENSIONS ET DES INVERSIONS DE POLATITÉ**
SCHUTZVORRICHTUNG GEGEN ÜBERSPANNUNGEN UND FALSCHPOLUNG
DEVICE FOR SURGE PROTECTION AND AGAINST REVERSE POLATITY

(30) Priorité: 27.03.2017 FR 1752516
(43) Date de publication de la demande: 03.10.2018
(73) Titulaire: STMicroelectronics (Tours) SAS, 37100 Tours (FR)
(72) Inventeur: RABIER, Philippe, 37300 JOUE-LES-TOURS (FR)
(74) Mandataire: Cabinet Beaumont

(56) Documents cités:
- WO-A1-2006/050568
- US-A1- 2010 141 170

## Description

### Domaine

La présente demande concerne un dispositif de protection contre les surtensions et plus particulièrement un dispositif de protection contre les surtensions adapté à la protection de composants reliés à une ligne d'alimentation.

### Exposé de l'art antérieur

Un véhicule est un environnement sujet à de nombreuses perturbations. Ainsi, les circuits électroniques d'un véhicule doivent être tout particulièrement protégés contre les surtensions. Un dispositif de protection contre les surtensions est un composant qui devient passant lorsque la tension à ses bornes dépasse un certain seuil, appelé couramment tension de claquage. Une diode à avalanche ou une diode de Schockley peuvent par exemple constituer un dispositif de protection élémentaire contre des surtensions.

L'alimentation électrique d'un véhicule est généralement constituée d'une batterie délivrant une tension nominale V_{Bat}, par exemple égale à 12 V pour une batterie de voiture. Le dispositif de protection contre les surtensions est donc adapté à se déclencher pour des surtensions de valeur supérieure, en valeur absolue, à la tension nominale V_{Bat} maximale délivrée par la batterie.

Lorsque la batterie d'un véhicule n'est plus assez chargée pour le faire démarrer, il est possible de la connecter en parallèle sur une autre batterie du même type de véhicule, une batterie d'un autre type de véhicule ou un chargeur de batterie pouvant délivrer une tension plus élevée que la tension nominale V_{Bat}, délivrée par la batterie du véhicule. En fonction du type de véhicule, la tension V_{Bat} peut prendre des valeurs par exemple égales à 6, 12, 24 ou 48 V. Une batterie de camion délivrant généralement une tension V_{BatExt} égale au double de celle d'une voiture, connecter une batterie de camion sur une batterie de voiture risquerait de déclencher le dispositif de protection contre les surtensions calibré pour une tension V_{Bat} de batterie de voiture.

D'autre part, pour des raisons de maintenance et de test, il arrive que l'on inverse volontairement les polarités de la batterie. Il faut, dans ce cas, une protection adaptée à supporter une tension égale à l'inverse de la tension de la batterie du véhicule, -V_{Bat}. Il existe donc un besoin dans la technique pour un dispositif de protection protégeant des circuits électroniques d'un véhicule contre des surtensions mais autorisant la connexion à une source d'énergie délivrant une tension V_{BatExt} plus élevée que la tension V_{Bat} et le branchement en inverse de la batterie du véhicule.

Le document WO 2006-050568 décrit un dispositif de protection contre les surtensions.

Le document US 2010-0141170 décrit un système de conversion de modulation alternatif-continu et son application.

### Résumé

Ainsi, un mode de réalisation prévoit un dispositif de protection contre les surtensions positives de valeur supérieure à V_{BatExt} et contre les surtensions négatives de valeur inférieure à -V_{Bat}.

On prévoit un dispositif de protection d'un circuit destiné à recevoir une tension d'alimentation, ce dispositif comprenant en série : une diode bidirectionnelle ayant une tension de claquage supérieure ou égale à la tension d'alimentation ; et une diode unidirectionnelle ayant une tension de claquage supérieure ou égale à la tension d'alimentation, l'une des diodes étant une diode à avalanche et l'autre étant une diode de Schockley.

Selon un mode de réalisation, la diode à avalanche est unidirectionnelle et la diode de Shockley est bidirectionnelle.

Selon un mode de réalisation, la diode à avalanche est bidirectionnelle et la diode de Shockley est unidirectionnelle et est en antiparallèle sur une diode de redressement.

Selon un mode de réalisation, la tension d'alimentation est comprise entre 6 et 48 V.

Selon un mode de réalisation, le circuit à protéger comprend des circuits d'un véhicule et dans lequel la tension d'alimentation est la tension nominale d'une batterie de véhicule.

Selon un mode de réalisation, le circuit à protéger comprend des circuits électroniques, logiques et/ou analogiques.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A est un schéma électrique d'un mode de réalisation d'un dispositif de protection contre les surtensions ;
la figure 1B illustre la caractéristique tension-courant du dispositif de la figure 1A ;
la figure 2A est un schéma électrique d'un autre mode de réalisation d'un dispositif de protection contre les surtensions ; et
la figure 2B illustre la caractéristique tension-courant du dispositif de la figure 2A.

### Description détaillée

De mêmes éléments ont été désignés par de mêmes références dans les différentes figures. Par souci de clarté, seuls les éléments utiles à la compréhension des modes de réalisation décrits ont été représentés et sont détaillés.

Sauf précision contraire, l'expression "de l'ordre de" signifie à 10 % près, de préférence à 5 % près.

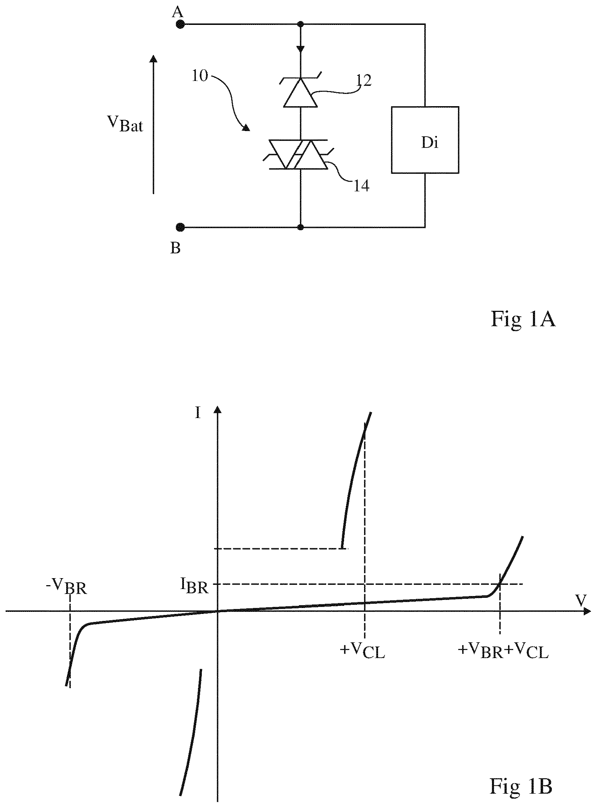

La figure 1A illustre un mode de réalisation d'un dispositif de protection adapté à protéger des circuits électroniques d'une voiture contre des surtensions positives de valeur supérieure à la tension nominale d'une batterie de camion et contre des surtensions négatives de valeur supérieure, en valeur absolue, à la tension nominale d'une batterie de voiture.

La figure 1A est un schéma électrique illustrant un dispositif de protection 10 connecté entre un noeud A et un noeud B d'un dispositif Di à protéger. Le dispositif Di comprend par exemple des circuits électroniques, logiques et/ou analogiques. Le dispositif 10 comprend en série, entre les noeuds A et B, une diode à avalanche unidirectionnelle 12 et une diode de Schockley bidirectionnelle 14. La cathode de la diode à avalanche 12 est reliée au noeud A et son anode est reliée à une des bornes de la diode de Schockley 14. Le dispositif Di est connecté par ses bornes A et B à une batterie délivrant une tension nominale V_{Bat}. A titre de variante, la cathode de la diode à avalanche 12 pourrait être reliée à une des bornes de la diode de Schockley bidirectionnelle 14 et son anode pourrait être reliée au noeud B.

La figure 1B illustre la caractéristique courant-tension du dispositif 10. La diode à avalanche a une tension d'avalanche V_{CL} supérieure à la tension nominale V_{Bat} d'une batterie de voiture. La tension d'avalanche V_{CL} est par exemple de l'ordre de 13 V pour une batterie de voiture ayant une tension nominale V_{Bat} de 12 V. La diode de Schockley 14 a une tension de claquage positive V_{BR} supérieure à la tension nominale V_{Bat} que délivre la batterie de la voiture et une tension de claquage négative égale à l'inverse de la tension de claquage positive -V_{BR}. Les tensions de claquage positive V_{BR} et négative -V_{BR} sont par exemple de 14 V et de -14 V pour une batterie de voiture délivrant une tension nominale V_{Bat} de 12 V. Le dispositif de protection 10 a donc une tension de claquage positive égale à la somme de la tension d'avalanche V_{CL} de la diode à avalanche 12 et de la tension de claquage positive V_{BR} de la diode de Schockley 14. Le dispositif 10 a une tension de claquage négative égale à la tension de claquage négative -V_{BR} de la diode de Schockley 14.

Ainsi, le dispositif 10 se déclenche pour des surtensions positives de valeur supérieure à la tension nominale V_{BatExt} d'une batterie de camion et pour des surtensions négatives de valeur supérieure, en valeur absolue, à la tension nominale d'une voiture V_{Bat}.

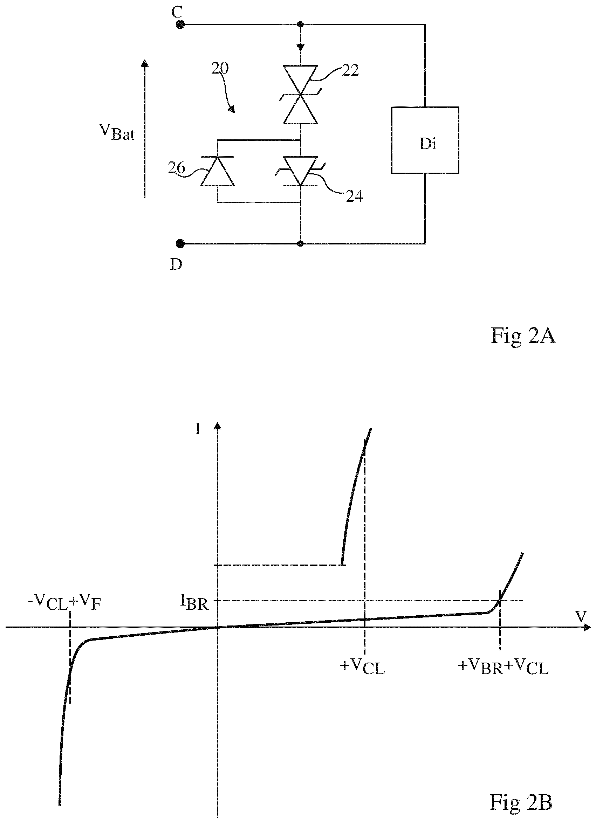

La figure 2A illustre un autre mode de réalisation d'un dispositif de protection adapté à protéger des circuits électroniques d'une voiture contre des surtensions positives de valeur supérieure à celle d'une batterie de camion V_{BatExt} et contre des surtensions négatives de valeur supérieure, en valeur absolue, à la tension d'une batterie de voiture V_{Bat}.

La figure 2A est un schéma électrique d'un dispositif de protection 20 connecté entre un noeud C et un noeud D du dispositif Di à protéger. Le dispositif de protection 20 comprend, en série entre les noeuds C et D, une diode à avalanche bidirectionnelle 22 et une diode de Schockley unidirectionnelle 24. La cathode de la diode de Schockley 24 est connectée au noeud D et son anode est connectée à la diode à avalanche 22. Le dispositif 20 comprend en outre une diode 26 connectée en antiparallèle de la diode de Schockley 24. Le dispositif Di est connecté par ses bornes C et D à une batterie délivrant une tension V_{Bat}. A titre de variante, la cathode de la diode de Schockley 24 pourrait être reliée à une des bornes de la diode à avalanche 22 et son anode pourrait être reliée au noeud C.

La figure 2B illustre la caractéristique tension-courant du dispositif 20. La diode à avalanche 22 a une tension d'avalanche positive V_{CL} supérieure à la tension nominale V_{Bat} d'une batterie d'un véhicule et une tension d'avalanche négative égale à l'inverse de la tension d'avalanche positive -V_{CL}. Les tensions d'avalanche positive V_{CL} et négative -V_{CL} sont par exemple de l'ordre de 13 V et de -13 V pour une tension nominale V_{Bat} de 12 V. La diode de Schockley 24 a une tension de claquage V_{BR} supérieure à la tension nominale V_{Bat} d'une batterie d'un véhicule. La tension de claquage V_{BR} est par exemple de l'ordre de 14 V pour une batterie d'un véhicule de tension nominale de 12 V. La diode 26 est une diode de redressement présentant une chute de tension en direct, V_{F}, de l'ordre de 0,6 V. Le dispositif 20 a une tension de claquage positive égale à la somme de la tension d'avalanche positive V_{CL} de la diode à avalanche 22 et de la tension de claquage V_{BR} de la diode de Schockley 24. De plus, la diode à avalanche 22 étant bidirectionnelle, le dispositif 20 a une tension de claquage négative égale à la somme de la tension d'avalanche négative -V_{CL} de la diode 22 et de la chute de tension en direct V_{F} de la diode 26.

Ainsi, le dispositif 20 se déclenche pour des surtensions positives de valeur supérieure à la tension nominale d'une batterie de camion et pour des surtensions négatives de valeur supérieure, en valeur absolue, à la tension nominale d'une voiture.

Comme le montre les figures 1B et 2B, pour des surtensions positives, les comportements électriques des dispositifs 10 et 20 sont identiques. Cependant, pour des surtensions négatives, le comportement du dispositif 10, décrit en relation avec la figure 1B, est celui d'une diode de Schockley et le comportement du dispositif 20, décrit en relation avec la figure 2B, est celui d'une diode à avalanche. Dans le cas d'une voiture, un fonctionnement à diode à avalanche n'est pas un inconvénient car, généralement, les surtensions négatives survenant dans une voiture sont de faible énergie.

De plus, si on inverse les branchements d'une batterie d'un véhicule, elle délivrera une tension de -V_{Bat} dans le dispositif de protection 10, 20 et dans le dispositif Di à protéger. Le dispositif de protection 10, 20 ne se déclenchant que pour des surtensions négatives de valeur inférieures à -V_{Bat}, la batterie ne sera pas court-circuitée et ne sera donc pas endommagée.

Des modes de réalisation particuliers ont été décrits. Diverses variantes et modifications apparaîtront à l'homme de l'art. En particulier, ce dispositif de protection contre les surtensions peut être utilisé dans n'importe quel environnement et pas seulement celui d'un véhicule.

Divers modes de réalisation avec diverses variantes ont été décrits ci-dessus. On notera que l'homme de l'art pourra combiner divers éléments de ces divers modes de réalisation et variantes sans faire preuve d'activité inventive.

## Revendications

1. Dispositif de protection (10) d'un circuit (Di) destiné à recevoir une tension d'alimentation (V_{Bat}), ce dispositif (10) comprenant en série :
une diode bidirectionnelle (14) ayant une tension de claquage (V_{BR}, V_{CL}) supérieure ou égale à la tension d'alimentation (V_{Bat}) ; et
une diode unidirectionnelle (12) ayant une tension de claquage (V_{CL}, V_{BR}) supérieure ou égale à la tension d'alimentation (V_{Bat}),
dans lequel la diode unidirectionnelle (12) est une diode à avalanche et la diode bidirectionnelle (14) est une diode de Schockley.

2. Dispositif de protection (20) d'un circuit (Di) destiné à recevoir une tension d'alimentation (V_{Bat}), ce dispositif (20) comprenant en série :
une diode bidirectionnelle (22) ayant une tension de claquage (V_{BR}, V_{CL}) supérieure ou égale à la tension d'alimentation (V_{Bat}) ; et
une diode unidirectionnelle (24) ayant une tension de claquage (V_{CL}, V_{BR}) supérieure ou égale à la tension d'alimentation (V_{Bat}),
dans lequel la diode bidirectionnelle (22) est une diode à avalanche et la diode unidirectionnelle (24) est une diode de Schockley et est en antiparallèle sur une diode de redressement (26) .

3. Dispositif de protection (20) selon le revendication 1 ou 2, dans lequel la tension d'alimentation (V_{Bat}) est comprise entre 6 et 48 V.

4. Ensemble comprenant un dispositif de protection selon l'une quelconque des revendications 1 à 3 et un circuit à protéger (Di) comprenant des circuits d'un véhicule et dans lequel la tension d'alimentation (V_{Bat}) est la tension nominale d'une batterie d'un véhicule.

5. Ensemble selon la revendication 4, dans lequel le circuit à protéger (Di) comprend des circuits électroniques, logiques et/ou analogiques.

## Patentansprüche

1. Schutzvorrichtung (10) für eine Schaltung (Di), die dazu bestimmt ist, eine Versorgungsspannung (V_{Bat}) zu empfangen, wobei die Vorrichtung (10) in Reihe Folgendes aufweist:
eine bidirektionale Diode (14) mit einer Durchbruchspannung (V_{BR}, V_{CL}), die größer oder gleich der Versorgungsspannung (V_{Bat}) ist; und
eine unidirektionale Diode (12) mit einer Durchbruchsspannung (V_{CL}, V_{BR}), die größer oder gleich der Versorgungsspannung (V_{Bat}) ist,
wobei die unidirektionale Diode (12) eine Avalanche-Diode ist und die bidirektionale Diode (14) eine Shockley-Diode ist.

2. Schutzvorrichtung (20) für eine Schaltung (Di), die dazu bestimmt ist, eine Versorgungsspannung (V_{Bat}) zu empfangen, wobei die Vorrichtung (20) in Reihe Folgendes aufweist:
eine bidirektionale Diode (22) mit einer Durchbruchspannung (V_{BR}, V_{CL}), die größer oder gleich der Versorgungsspannung (V_{Bat}) ist; und
eine unidirektionale Diode (24) mit einer Durchbruchsspannung (V_{CL}, V_{BR}), die größer oder gleich der Versorgungsspannung (V_{Bat}) ist,
wobei die bidirektionale Diode (22) eine Avalanche-Diode ist und die unidirektionale Diode (24) eine Shockley-Diode ist, und antiparallel mit einer Gleichrichterdiode (26) geschaltet.

3. Schutzeinrichtung (20) nach Anspruch 1 oder 2, wobei die Versorgungsspannung (V_{Bat}) zwischen 6 und 48 V liegt.

4. Anordnung aufweisend eine Schutzeinrichtung nach einem der Ansprüche 1 bis 3 und eine zu schützende Schaltung (Di) mit Schaltkreisen eines Fahrzeugs und wobei die Versorgungsspannung (V_{Bat}) die Nennspannung einer Batterie eines Fahrzeugs ist.

5. Anordnung nach Anspruch 4, wobei die zu schützende Schaltung (Di) elektronische, logische und/oder analoge Schaltungen aufweist.

## Claims

1. Protection device (10) for a circuit (Di) intended to receive a supply voltage (V_{Bat}), this device (10) comprising, in series:
a bidirectional diode (14) having a breakdown voltage (V_{BR}, V_{CL}) that is higher than or equal to the supply voltage (V_{Bat}) ; and
a unidirectional diode (12) having a breakdown voltage (V_{CL}, V_{BR}) that is higher than or equal to the supply voltage (V_{Bat}),
wherein the unidirectional diode (12) is an avalanche diode and the bidirectional diode (14) is a Shockley diode.

2. Protection device (20) for a circuit (Di) intended to receive a supply voltage (V_{Bat}), this device (20) comprising, in series:
a bidirectional diode (22) having a breakdown voltage (V_{BR}, V_{CL}) that is higher than or equal to the supply voltage (V_{Bat}) ; and
a unidirectional diode (24) having a breakdown voltage (V_{CL}, V_{BR}) that is higher than or equal to the supply voltage (V_{Bat}),
wherein the bidirectional diode (22) is an avalanche diode and the unidirectional diode (24) is a Shockley diode and is connected in antiparallel with a rectifier diode (26).

3. Protection device (20) according to claims 1 or 2, wherein the supply voltage (V_{Bat}) is between 6 and 48 V.

4. Assembly comprising a protection device according to any one of Claims 1 to 3 and a circuit to be protected (Di) comprising circuits of a vehicle and wherein the supply voltage (V_{Bat}) is the nominal voltage of a battery of a vehicle.

5. Assembly according to claim 4, wherein the circuit to be protected (Di) comprises electronic, logic and/or analogue circuits.
